# EUROPÄISCHE PATENTSCHRIFT

(11) **EP 0 843 748 B1**
(45) Veröffentlichungstag und Bekanntmachung des Hinweises auf die Patenterteilung: **27.06.2001**
(21) Anmeldenummer: 96931737.9
(22) Anmeldetag: 26.07.1996
(51) Int. Cl.: C30B 25/18, C30B 11/12

(54) **VERFAHREN ZUR HERSTELLUNG VON KRISTALLINEN SCHICHTEN**
METHOD OF PRODUCING CRYSTALLINE LAYERS
PROCEDE DE PRODUCTION DE COUCHES CRISTALLINES

(30) Priorität: 28.07.1995 DE 19529027; 28.07.1995 DE 19529029
(43) Veröffentlichungstag der Anmeldung: 27.05.1998
(73) Patentinhaber: Forschungsverbund Berlin e.V., 12489 Berlin (DE)
(72) Erfinder: BOECK, Torsten, 10367 Berlin (DE); SCHMIDT, Klaus, 12487 Berlin (DE); BRAUN, Andreas, 12555 Berlin (DE)
(74) Vertreter: Rudolph, Margit
(86) Internationale Anmeldenummer: DE9601439
(87) Internationale Veröffentlichungsnummer: WO9705304

(56) Entgegenhaltungen:
- DE-A- 1 901 752
- US-A- 4 534 820
- APPLIED PHYSICS LETTERS, Bd. 61, Nr. 21, 23.November 1992, NEW YORK US, Seiten 2557-2559, XP000324842 YAMAGATA ET AL.: "selective growth of Si crystals from the agglomerated Si seeds over amorphous substrates" in der Anmeldung erwähnt
- JOURNAL OF THE ELECTROCHEMICAL SOCIETY, Bd. 128, Nr. 1, Januar 1981, MANCHESTER, NEW HAMPSHIRE US, Seiten 154-161, XP002022086 VAN ENCKEVORT ET AL.: "growth mechanisms of Silicon crystallites grown on top of a metal coated Graphite substrate"
- PATENT ABSTRACTS OF JAPAN vol. 8, no. 172 (C-237) [1609] , 9.August 1984 & JP 59 069495 A (NIPPON DENSHIN), 19.April 1984,

## Beschreibung

Die Erfindung bezieht sich auf ein Verfahren zur Herstellung von kristallinen Schichten, bei dem auf einem Substrat örtlich selektiv Keimzentren auf der Oberfläche des Substrats erzeugt werden.

Für die Herstellung von kristallinen Schichten auf kristallinen Substraten haben die Epitaxieverfahren eine breite Anwendung gefunden. Hierbei erfolgt ein gesetzmäßig orientiertes Aufwachsen einer Kristallschicht aus - im Vergleich zum Substrat - arteigenem bzw. artähnlichem Material auf dem Substrat. Jedoch können mit diesen Verfahren nur Schichten mit begrenzten Abmessungen realisiert werden. Außerdem muß ein Substrat mit kristalliner Struktur zur Verfügung stehen, was erhöhte Kosten erfordert.

Häufig sind amorphe Substrate zwingend für das Einsatzgebiet (z.B. Verwendung von Glas für Displays) oder das Funktionsprinzip eines Bauelements erfordert die Abscheidung auf einer amorphen Schicht (z.B. Schichtpakete in 3D-Bauelementen mit Isolatorzwischenschichten). Für großflächige Anwendungen aber schließen oft wirtschaftliche Aspekte den Einsatz von aus physikalischer Sicht geeigneten kristallinen Substraten aus.

Deshalb gibt es schon seit vielen Jahren Bemühungen, Verfahren zu entwickeln, die Abscheidungen kristalliner Schichten auf wirtschaftlich günstigen Substraten ermöglichen. Ziel ist es dabei, ein amorphes Substrat derart zu behandeln, daß eine Unterlage mit kristallographischer Orientierung für ein anschließendes epitaktisches Aufwachsen einer Kristallschicht zur Verfügung gestellt wird.

Der Stand der Technik, von dem die Erfindung ausgeht, ist den im folgenden erwähnten Veröffentlichungen zu entnehmen. In Appl. Phys. Lett. 35(1), 1 July 1979, pp. 71 wird das Verfahren der sogenannten "Graphoepitaxie" beschrieben, bei dem in einem Glassubstrat künstlich ein Oberfächenrelief, beispielsweise mit Gitter- oder Facettenstruktur, durch Ätzen erzeugt wird, darauf ein amorphes Schichtmaterial abgeschieden und durch Laserrekristallisation in eine polykristalline Schicht umgewandelt wird. Dabei bedingt das Oberflächenrelief bestimmte kristallographische Vorzugsorientierungen der entstehenden polykristallinen Schicht.

Nachteilig ist in diesem Verfahren die auftretende Aufrauhung der Schichtoberfläche durch den Laserrekristallisationsprozeß, da dieser von einem lateralen Massetransfer des Schichtmaterials begleitet wird.

Ein Verfahren zur Herstellung isolierender Substrate ist in DD 228 838 beschrieben. Hierbei wird auf einer aus geschmolzenem Quarzglas hergestellten Unterlage ein System von isolierenden Schichten (SiO₂- und Si₃N₄-Schichten) und abschließend eine Halbleiterschicht (Si) aufgebracht und diese rekristallisiert. Dieses Verfahren erfordert sehr spezifische technologische und kristallographische Parameter in Abhängigkeit der abzuscheidenden Materialien.

Bei der in DD 238 172 aufgezeigten technischen Lösung wird auf einem möglichst glatten Substrat eine amorphe organische Schicht abgeschieden, in die mittels Holographie geeignete Strich-, Punkt-, Flächengitter oder ähnliche Gebilde mit großer Flankensteilheit bei gleichzeitiger Gewährleistung homogener Seitenflächen eingeschrieben werden. Auf diese Reliefstruktur werden dann Schichten aufgebracht, die einkristallin in einer durch das Relief bevorzugten Struktur aufwachsen. Dieses Verfahren erfordert einen großen technologischen Aufwand.

In DD 152 816 wird ein Verfahren zur Herstellung von monokristallinen Schichten beschrieben, bei dem auf einem Substrat wiederum künstlich ein Oberflächenrelief erzeugt wird und anschließend mittels eines Sputterprozesses Teilchen zum strukturierten Substrat transportiert werden, die dort Depositionsenergien aufweisen, die eine erhöhte Migrationsfähigkeit der kondensierenden Teilchen bedingen. Sputterprozesse jedoch gewährleisten keine hohe Reinheit der aufgebrachten Schicht, die notwendig wäre für einen hohen Wirkungsgrad von Solarzellen, der von den elektrischen und optischen Eigenschaften der aktiven Schicht beeinflußt wird.

Das Wachstum von polykristallinem Silizium auf Graphit aus flüssigen Zinnschichten wurde in "Proceedings of the 2nd E.C. Photovoltaic Solar Energy Conference", D. Reidel Publ. Company, Dordrecht, 1979, S. 759 beschrieben. Die notwendigen hohen Temperaturen von 1230 °C und die Verwendung giftiger Gase sind bei diesem Verfahren jedoch sehr problematisch.

In Appl. Phys. Lett. 61 (1992), S. 2557 ff. wird das selektive Wachstum von bis zu 100 µm großen, pyramidalen Si-Kristallen auf amorphen Substraten aus agglomerierten , Si-Keimen beschrieben. Thermisch oxydierte Si-Wafer wurden durch LPCVD (low pressure chemical vapor deposition) bei 620 °C mit 100 nm dicken, mikrokristallinen Si-Schichten versehen und bei Temperaturen von 1000 °C bis 1200 °C getempert. Vor der Temperung wurden die mikrokristallinen Schichten photolithographisch strukturiert. Durch örtliche Separierung in voneinander getrennt beschichtete Gebiete definierter Größe konnten innerhalb der Si-beschichteten Gebiete durch Agglomerationsvorgänge während der Temperung einkristalline Si-Keime im 10 nm-Bereich hergestellt werden. In einem anschließenden CVD-Prozeß wurden die Keime vergrößert. Durch epitaktisches Wachstum an den Keimen und durch Überwachsen der amorphen Unterlage entstanden große, regelmäßig angeordnete pyramidale Si-Kristalle mit Basisflächen von (100 x 100) µm². Diese Lösung erfordert ebenfalls wieder hohe Temperaturen und erfordert damit die Verwendung hochtemperaturbeständiger Substrate wie beispielsweise Si-Wafer oder Kieselglas. Außerdem ist die Strukturierung durch Photolithographie für großflächige Anwendungen wirtschaftlich unzweckmäßig.

In US 4,534,820 wird ein Verfahren zur Herstellung eines kristallinen Films beschrieben, bei dem auf einem Substrat örtlich selektiv Keimzentren auf seiner Oberfläche erzeugt werden. Dies geschieht dadurch, daß zunächst auf ein planares amorphes oder metallisches Substrat ein dünner Film eines Metalls abgeschieden wird, dieser Metallfilm derart periodisch strukturiert wird, daß sowohl das Gesamtensemble als auch jedes einzelne Element der Struktur bereits die gleiche Rotationssymmetrie aufweist wie die kristalline Achse der parallel zur Substratoberfläche aufzuwachsenden Kristallfläche des Halbleiterfilms. Damit sind bereits bevorzugte kristallographische Orientierungen für den aufzubringenden und auszukristallisierenden Halbleiterfilm in dem Lösungsmittel vorgegeben. Das Substrat mit dem aufgebrachten Metallfilm wird dann auf eine Temperatur erwärmt, die größer als die eutektische Temperatur des Metalls und des Halbleitermaterials ist, das auskristallisieren soll. Anschließend wird das Halbleitermaterial auf das Substrat aufgebracht, das nun örtlich selektive, periodisch angeordnete und eine definierte kristallographische Vorzugsorientierung bzgl. des Halbleitermaterials besitzende Keimzentren aufweist. Das Halbleitermaterial lagert sich im weiteren Verfahrensverlauf ab und kristallisiert zunächst in einem Film aus, auf den dann ein einkristalliner Film aufgewachsen wird. Bezüglich der vorzugebenden Strukturierung und/oder Orientierung des Lösungsmittels ist dieses Verfahren sehr aufwendig.

Über ein Verfahren zum Aufwachsen von Si-Einkristallen auf einem Substrat wird in DE 1901 752 berichtet. Mit diesem Verfahren werden diskrete Einkristalle, die auch elektrisch voneinander getrennt sind, aus dielektrischem Material selektiv gezüchtet. Ein nichtmonokristallines Substrat wird mit zylindrischen Vertiefungen versehen. Der Querschnitt dieser Vertiefungen ist so groß gewählt, daß er für die technische Anwendung des gezüchteten Einkristalls ausreichend ist (z. B. 0,012 m im Durchmesser; die Höhe beträgt 0,005 bis 0,01 m). In diese Vertiefungen wird ein Legierungsmetall eingebracht und in einer inerten Atmosphäre bis zum Schmelzen erhitzt. Das Legierungsmetall wird mit einer Atmosphäre in Kontakt gebracht, welche Silizium enthält, wobei das Legierungsmetall weiterhin erhitzt und auf eine Temperatur gebracht wird, die größer ist als die eutektische Temperatur der beiden genannten Materialien, und zwar solange, bis das Silizium im Legierungsmetall absorbiert ist. Dann wird ein ausreichender Temperaturgradient am Legierungsmetall erzeugt, um an nur einer einzelnen Stelle des Metalls mit der höheren Temperatur des Gradienten Keimbildung zu erzeugen, wobei am oberen Teil des Legierungsmetalls die Atmosphäre mit Silizium in Kontakt mit dem Legierungsmetall gehalten wird, während sich das Legierungsmetall auf einer Temperatur befindet, die über der eutektischen Temperatur des Metalls und des Silizium liegt, bis die gewünschte Höhe des Einkristalls erreicht ist, der ohne Vereinzelung wegen seiner Größe in nun folgenden Verfahrensschritten zu einem Bauelement vervollständigt werden kann.

Die Möglichkeit des Überwachsens amorpher Bereiche bei Vorhandensein einkristalliner Keimzentren wurde in Appl. Phys. A, 57 (1993), S. 249 ff. beschrieben. Ebenfalls unter Verwendung von thermisch oxydierten, einkristallinen Si-Wafern wurden sogenannte Saatfenster in die Oxidschicht geätzt. Durch anschließende Flüssigphasenepitaxie gelang die Herstellung von bis zu 400 µm großen, einkristallinen Si-Lamellen. Die Züchtung aus der Lösung ermöglichte zwar das Wachstum bei geringeren Temperaturen, für die epitaktische Strukturinformation war aber dennoch der Einsatz von perfekten, kristallinen Wafern notwendig. Die Herstellung großer, glatter Schichten bzw. weiträumig ausgedehnter, geometrisch gleichförmiger Einzelstrukturen ist wegen der beim LPE-Verfahren auftretenden Konvektionsvorgänge schwer beherrschbar.

Neben den bereits genannten Nachteilen ist es bisher mit keiner der beschriebenen Lösungen des Standes der Technik gelungen, monokristalline Schichten oder polykristalline Schichten mit hinreichender Korngröße und ausreichender morphologischer Perfektion, insbesondere für die Herstellung von Solarzellen mit hohem Wirkungsgrad, großflächig auf den vorbereiteten Unterlagen aufzuwachsen.

Aufgabe der Erfindung ist es deshalb, ein Verfahren anzugeben, das die Herstellung von großflächigen kristallinen Schichten auf billigen Trägern ermöglicht.

Die Aufgabe wird dadurch gelöst, daß in einem Verfahren der eingangs erwähnten Art erfindungsgemäß zur Erzeugung der örtlich selektiven Keimzentren auf die Substratoberfläche ein Lösungsmittel aufgebracht und eine solche Temperatur eingestellt wird, bei der eine Tröpfchenbildung des Lösungsmittels erfolgt, danach der zu kristallisierende Stoff abgeschieden und die Temperatur größer oder gleich der Liquidustemperatur eingestellt wird, nach dem Lösen des zu kristallisierenden Stoffes in dem Lösungsmittel die Temperatur für die Kristallitbildung an der Grenzfläche Lösung/Substrat verringert wird und abschließend diese Kristallite zu einer vollständig geschlossenen kristallinen Schicht ausgewachsen werden.

Bei dem erfindungsgemäßen Verfahren wird auf einem beliebigen Substrat gezielt eine selektive Keimbildung hervorgerufen.

Mit dem Aufbringen des Lösungsmittels auf einem beliebigen Substrat und der Bildung von Lösungsmitteltröpfchen durch anschließende thermische Koaleszenz wird ein strukturiert angeordnetes Lösungsmittel erzeugt. Ein strukturiert angeordnetes Lösungsmittel wird ebenfalls erhalten, wenn ein Substrat mit Oberflächenrelief verwendet wird und darauf das Lösungsmittel aufgebracht wird. Wird nun der zu kristallisierende Stoff auf das Lösungsmittel aufgetragen, die Temperatur eine hinreichende Zeit größer oder gleich der Liquidustemperatur eingestellt, so wird in dem Lösungsmittel der zu kristallisierende Stoff gelöst. Bei anschließender Temperaturverringerung werden durch Kristallisationsmechanismen zunächst Keime erzeugt, die im folgenden durch epitaktisches Auswachsen und laterales Überwachsen des Substrates eine geschlossene kristalline Schicht bilden.

Mit der Verwendung von Lösungsmitteln im erfindungsgemäßen Verfahren wird einerseits garantiert, daß ein Teil der auftretenden Verunreinigungen in der Lösung verbleibt und nicht in den Festkörper eingebaut wird und andererseits, daß eine hohe Beweglichkeit der kondensierenden Teilchen realisiert wird.

Das erfindungsgemäße Verfahren gestattet die Herstellung großflächiger kristalliner Schichten hoher Reinheit mit einstellbaren Korngrößen auf beliebigen Substraten, einschließlich amorpher Substrate, die keine Vorzugsorientierung beim Erzeugen und Auswachsen der Keime bewirken; d.h., an die Morphologie des Substrates müssen keine besonderen Anforderungen gestellt werden.

In Ausführungsformen ist deshalb vorgesehen, daß als Substrat Glas oder Keramik verwendet wird. Es wird also möglich, ein billiges Substrat einzusetzen, da dieses keine kristalline Struktur aufweisen muß. Weiterhin kann ein solches Substrat verwendet werden - wie bereits erwähnt -, das ein Oberflächenrelief aufweist.

Das Aufbringen der Lösungsmittelschicht auf das Substrat kann durch Anwendung verschiedener, derzeit technologisch gut beherrschbarer Verfahren erfolgen. Beispielhaft seien hier genannt: thermisches oder Elektronenstrahlverdampfen, Sputtern, laserinduzierte Abscheidung, chemische Gasphasenabscheidung.

Beispielsweise durch Variation der Menge des abgeschiedenen Lösungsmittels und der Substrattemperatur sind die Größe der Tröpfchen und ihre Verteilungsdichte einstellbar.

In Ausführungsformen der Erfindung wird zur Bildung von Lösungsmitteltröpfchen das Substrat bereits während des Aufbringens der Lösungsmittelschicht bzw. im Anschluß daran erwärmt.

Die Strukturierung der Oberfläche des amorphen Substrates erfolgt in einer Ausführungsform mittels eines Kurzpulslasers, insbesondere eines Femtosekundenlasers. Der Einsatz von Kurzpulslasern ist besonders vorteilhaft, da hierdurch Oberflächenstrukturen im Mikrometer- und Submikrometerbereich mit geringer Feingestaltsabweichung erzeugt werden können. Außerdem sind die Einstellung eines exakten geometrischen Musters der Strukturierung und eine getrennte Variation von Gestalt und Verteilung der Vertiefungen auf der Substratoberfläche möglich. Weiterhin sind als Verfahren zur Erzeugung der Oberflächenstruktur des Substrats das chemische Ätzen und die mechanische Strukturierung in Ausführungsformen vorgesehen.

Auch das Abscheiden des zu kristallisierenden Stoffes kann mit verschiedenen Verfahren, u.a. den bereits oben für das Aufbringen der Lösungsmittelschicht genannten, in weiteren Ausführungsformen auf die in flüssiger oder fester Form vorliegenden Lösungsmitteltröpfchen erfolgen.

Es ist in einer weiteren Ausführungsform vorgesehen, Lösungsmittel und zu kristallisierenden Stoff in einem Koprozeß gleichzeitig aus separaten Quellen auf das Substrat abzuscheiden.

In einer anderen Ausführungsform wird das Lösungsmittel gemeinsam mit in bereits gelöster bzw. fein disperser Form vorliegendem zu kristallisierenden Stoff abgeschieden.

Die beiden letztgenannten Ausführungsformen stellen eine Vereinfachung der Herstellung der für eine Kristallitbildung notwendigen Schichtfolge bzw. Schichtzusammensetzung dar.

In einer weiteren Ausführungsform erfolgt das Aufbringen des Lösungsmittels und das Aufbringen des zu kristallisierenden Stoffes mindestens teilweise zeitlich zueinander versetzt. Damit wird der Anlösungsprozeß des zu kristallisierenden Stoffes unterstützt.

Die Menge des abzuscheidenden Stoffes wird in Abhängigkeit von der Menge des Lösungmittels durch Auswertung der Konzentrations- und Temperaturverhältnisse des entsprechenden Zustandsdiagramms bestimmt.

Werden Lösungsmittel und zu kristallisierender Stoff in einem Koprozeß auf ein Substrat abgeschieden, wird zur Tröpfchenbildung in weiteren Ausführungsformen das Substrat während bzw. nach erfolgter Abscheidung erwärmt.

Bereits in Tröpfchenform wird das Lösungsmittel auf dem Substrat erhalten, wenn - ähnlich dem Funktionsprinzip eines Tintendruckers - das Lösungsmittel aufgebracht wird. In dieser erfindungsgemäßen Ausführungsform kann die definierte Anordnung der Tröpfchen sehr genau eingestellt und ihre Verteilung auf dem Substrat unabhängig von ihrer Gestalt varriiert werden.

In anderen Ausführungsformen wird ein Lösungstropfen bzw. eine Lösungsschicht, in denen der zu kristallisierende Stoff weitgehend vollständig gelöst ist, dadurch erzeugt, daß die Verfahrensschritte Aufbringen des Lösungsmittels und Aufbringen des zu kristallisierenden Stoffes mehrmals wiederholt werden. Durch die Erzeugung einer Schichtfolge Lösungsmittelschicht/zu kristallisierender Stoff/Lösungsmittelschicht usw., eventuell mit graduiertem Übergang, wird eine makroskopisch gleiche Zusammensetzung in einem vergrößerten Volumen erzeugt, wodurch eine wesentlich schnellere Homogenisierung im Lösungsprozeß erfolgt. Diese Schichtfolge tritt bei der Strukturierung mittels Tröpfchen dann auch in dieser geometrischen Form eines Tropfens auf.

In weiteren Ausführungsformen ist unter Beachtung der entsprechenden Zustandsdiagramme die Herstellung von kristallinen Schichten aus Elementen bzw. Mischkristallverbindungen und die Verwendung ein- bzw. mehrkomponentiger Lösungsmittel vorgesehen.

Zur Erhöhung der Haftfestigkeit des zu kristallisierenden Stoffes ist es gegebenenfalls vorteilhaft, vor der Abscheidung des Lösungsmittels eine Haftvermittlungsschicht aufzubringen.

Um den zu kristallisierenden Stoff im Lösungsmittel zu lösen, werden die abgeschiedenen Materialien eine hinreichende Zeit auf einer Temperatur, die größer oder gleich der entsprechenden Liquidustemperatur ist, gehalten.

Hinsichtlich des für die Kristallitbildung notwendigen Materialtransports ist es bereits in der Lösungsphase vorteilhaft, die Wärmezufuhr so zu gestalten, daß hauptsächlich das aufgebrachte Lösungsmittel und der zu kristallisierende Stoff erwärmt werden, nicht aber das Substratvolumen. Besonders hierfür geeignet sind die schnelle Lampenheizung mit einer Wellenlänge, die vom Lösungsmittel und zu kristallisierenden Stoff besser absorbiert wird als vom Substrat, die HF-Heizung und die Mikrowellenheizung, da mit diesen Heizungen die Wärmezufuhr lokal in einer bestimmten Tiefe der Schichtstruktur und selektiv gesteuert werden kann.

Für die Kristallitbildung ist ein gerichteter Materialtransport des gelösten Stoffes vom Lösungsvolumen zur Substratoberfläche notwendig. Es wird hierfür ein Gradient im chemischen Potential über eine Temperaturdifferenz zwischen der Lösungsoberfläche und dem grenzflächennahen Gebiet Lösung/Substrat realisiert, so daß für die Kristallitbildung an der Grenzfläche Lösung/Substrat die Liquidustemperatur unterschritten wird. Für die Strukturierung mittels Lösungströpfchen wird die Temperaturdifferenz zwischen der Tröpfchenoberfläche und dem grenzflächennahen Gebiet Lösungstropfen/Substrat eingestellt, im Falle der Verwendung eines Substrats mit Oberflächenrelief zwischen der Lösungsschichtoberfläche und der Spitze der Vertiefung. Die Temperaturdifferenz kann in einer vorteilhaften Ausführungsform - auch hier mit den bereits bei der Bildung der Lösung beschriebenen Heizungen - selektiv eingestellt werden.

In einer weiteren Ausführungsform wird die Substratrückseite aktiv gekühlt, beispielsweise durch den Einsatz einer wasserdurchflossenen Platte.

Auf dem nunmehr mit Kristalliten strukturierten Substrat werden Kristall- und schichtbildende Teilchen an der Oberfläche der Kristallite epitaktisch angelagert, damit die Kristallite zu einzelnen Kristallen hinreichender Größe bzw. geschlossenen Schichten ausreichender Dicke auswachsen können. Das Auswachsen der Kristallite kann mittels der bereits zu den Verfahrensschritten Abscheiden des Lösungsmittels und des zu kristallisierenden Stoffes beschriebenen Verfahren in situ erfolgen, es sind aber auch ex situ-Varianten möglich, wie es in weiteren Ausführungsformen vorgesehen ist.

Als ex situ-Verfahren für das Auswachsen der Kristallite sind beispielhaft zu nennen die Flüssigphasenepitaxie (LPE) und die chemische Gasphasenabscheidung (CVD). Bei der LPE, z.B. nach der Temperatur-Differenz-Methode, kann eine in ihrer Zusammensetzung der Tröpfchenphase bzw. der verbleibenden Schmelzlösung angepaßte Ausgangslösung verwendet werden, so daß die nach der Kristallitbildung erhalten bleibende Tröpfchenphase bzw. Schmelzlösung eine Passivierung der Kristallitoberflächen darstellt.

Durch Anwendung des VLS-Züchtungsprinzips (Vapour-Liquid-Solid) kann ein Auswachsen der Kristallite sowohl als in situ- als auch als ex situ-Prozeß erfolgen.

Werden für das Auswachsen der Kristallite freie Kristallitoberflächen benötigt, wird in anderen Ausführungsformen der Tröpfchenrest bzw. die verbleibende Schmelzlösung entfernt. Das kann z.B. durch selektives Abätzen bzw. Lösen der Tröpfchenphase bzw. der verbleibenden Schmelzlösung realisiert werden.

Die Erfindung wird anhand der folgenden Ausführungsbeipiele näher erläutert.

Dabei zeigen:
- Fig. 1:: schematisch Verfahrensschritte zur selektiven Keimbildung durch Herstellung einer strukturierten Unterlage mittels Tröpfchenbildung;

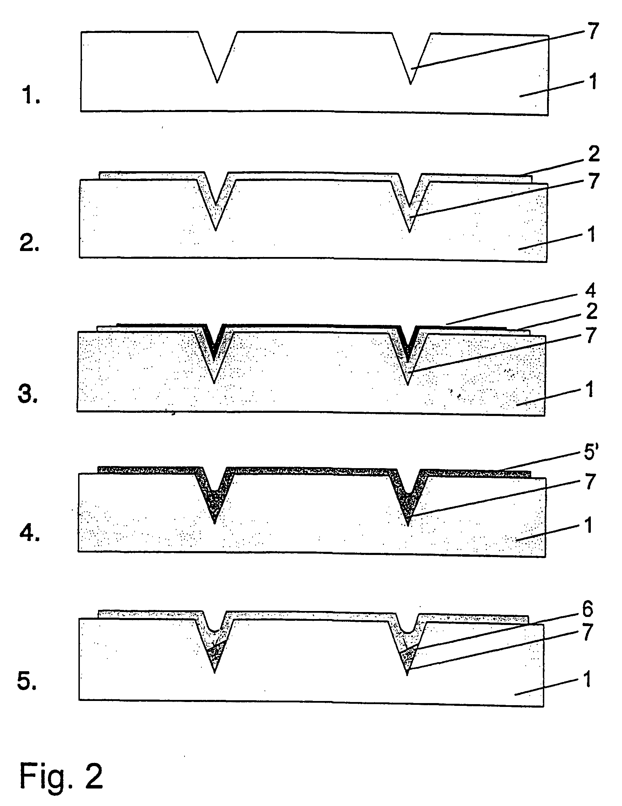

- Fig. 2:: schematisch Verfahrensschritte zur selektiven Keimbildung durch Verwendung einer Unterlage mit Oberflächenrelief.

### Ausführungsbeispiel 1

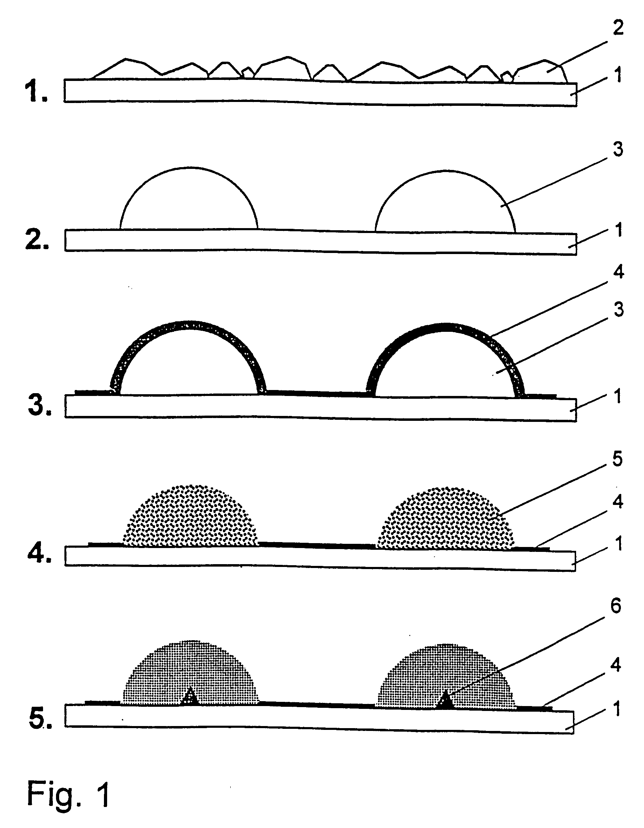

Für das erste Ausführungsbeispiel sind folgende Schritte des Herstellungsprozesses in Fig. 1 dargestellt:
1. Auf einem gereinigten amorphen Substrat **1,** z.B. Glas, wird ein Lösungsmittel **2,** z.B. In, mittels thermischen Verdampfens abgeschieden.
2. Wird nun das Glas-Substrat **1** erwärmt, bilden sich aufgrund des Koaleszenzverhaltens durch Oberflächenspannungsminimierung Lösungsmitteltröpfchen **3.**
3. Anschließend wird auf diese Tröpfchen **3** und das von diesen Tröpfchen nicht bedeckte Substrat **1** der zu kristallisierende Stoff **4,** z.B. Si, mittels Elektronenstrahlverdampfens abgeschieden.
4. Nun wird dem zu kristallisierenden Stoff **4** und dem Lösungsmitteltröpfchen **3,** das von diesem bedeckt ist, selektiv Wärme zugeführt, d.h. die Temperatur der beiden Komponenten bei > 650 °C mittels Lampenheizung eingestellt und 1 min gehalten. Die verwendete Lampe weist ein Intensitätsmaximum der Strahlung bei einer Wellenlänge von 1,1 µm auf, die von Si und In besser absorbiert wird als vom Glassubstrat. Entsprechend der eingestellten Konzentrationsverhältnisse ist diese Temperatur höher als die Liquidustemperatur, so daß das Si im In gelöst wird und nun ein In-Si-Lösungstropfen **5** vorliegt. Der Wärmeeintrag ist hierfür so zu organisieren, daß ein stationärer Temperaturgradient zwischen Lösungsoberfläche und Substrat aufrechterhalten wird. Eine höhere Temperatur an der Tröpfchenoberfläche bedingt, vermittelt durch eine höhere Silizium-Löslichkeit im Grenzbereich Lösungsmittel/zu kristallisierender Stoff, einen Konzentrationsgradienten. Damit existiert eine thermodynamische Triebkraft für den Stofftransport.
5. Für die Kristallitbildung wird eine Temperatur an der Grenzfläche zum Substrat eingestellt, die niedriger ist als o.g. Liquidustemperatur. Die entstehende Temperaturdifferenz bewirkt einen für die Kristallitbildung erforderlichen Gradienten im chemischen Potential, es werden also an der Grenzfläche Substrat **1**/Lösungstropfen **5** Kristallite **6** gebildet.

Somit steht für das epitaktische Auswachsen einzelner Kristalle bzw. einer geschlossenen Schicht eine strukturierte Unterlage zur Verfügung.

Zur Erhöhung der Haftfestigkeit des zu kristallisierenden Stoffes, hier wie bereits erwähnt Si, kann es von Vorteil sein, vor der Abscheidung des Lösungsmittels eine Haftvermittlungsschicht, beispielsweise eine Al-Schicht, aufzubringen.

### Ausführungsbeispiel 2

Für das zweite Ausführungsbeispiel sind entsprechend die folgenden Schritte des Herstellungsprozesses dargestellt:
1. In einem amorphen Substrat **1**, z.B. Glas, werden kegelförmige Vertiefungen **7** in gleichmäßigem Abstand mit Hilfe eines Kurzpulslasers erzeugt.
2. Auf dieses oberflächenstrukturierte Substrat **1** wird nun ein Lösungsmittel **2**, z.B. In, mittels thermischen Verdampfens abgeschieden.
3. Anschließend wird auf die das Oberflächenrelief des Substrats bedeckende Lösungsmittelschicht **2** der zu kristallisierende Stoff **4,** z.B. Si, mittels Elektronenstrahlverdampfens abgeschieden.
4. Nun wird dem zu kristallisierenden Stoff **4** und der Lösungsmittelschicht **2,** das von diesem bedeckt ist, in den Vertiefungen **7** des Substrats **1** selektiv Wärme zugeführt, d.h. die Temperatur der beiden Komponenten bei > 650 °C mittels Lampenheizung eingestellt und 1 min gehalten. Die verwendete Lampe weist ein Intensitätsmaximum der Strahlung bei einer Wellenlänge von 1,1 um auf, die von Si und In besser absorbiert wird als vom Glassubstrat. Entsprechend der eingestellten Konzentrationsverhältnisse ist diese Temperatur höher als die Liquidustemperatur, so daß das Si im In gelöst wird und nun eine In-Si-Lösungsschicht **5'** vorliegt.
5. Für die Kristallitbildung wird in der Vertiefung **7** eine Temperatur an der Grenzfläche zum Substrat **1** eingestellt, die niedriger ist als o.g. Liquidustemperatur. Die entstehende Temperaturdifferenz bewirkt einen für die Kristallitbildung erforderlichen Gradienten im chemischen Potential, es werden also in der Vertiefung an der Grenzfläche Substrat **1**/Lösungsschicht **5'** Kristallite **6** gebildet.

Auch mit diesem Ausführungsbeispiel wird ein für das epitaktische Auswachsen einzelner Kristalle bzw. einer geschlossenen Schicht strukturiertes Substrat zur Verfügung gestellt. Zur Erhöhung der Haftfestigkeit des zu kristallisierenden Stoffes kann es auch in diesem Ausführungsbeispiel vorteilhaft sein, eine Al-Haftvermittlungsschicht vor der Abscheidung des Lösungsmittels aufzubringen.

Hervorzuheben sind die wesentlich niedrigeren Temperaturen im erfindungsgemäßen Verfahren im Vergleich mit den in den dem Stand der Technik nach bekannten Verfahren.

Die auf der Substratoberfläche erfindungsgemäß erzeugten Kristallite werden durch Zufuhr von weiterem Kristallisationsmaterial in situ oder ex situ zu geschlossenen, schichtartigen Strukturen ausgewachsen.

Mit dem erfindungsgemäßen Verfahren können insbesondere großflächige Si-Solarzellen mit hohem Wirkungsgrad kostengünstig hergestellt werden.

## Patentansprüche

1. Verfahren zur Herstellung von kristallinen Schichten, bei dem auf einem Substrat örtlich selektiv Keimzentren auf der Oberfläche des Substrats erzeugt werden,
**dadurch gekennzeichnet, daß**
zur Erzeugung der örtlich selektiven Keimzentren auf die Substratoberfläche ein Lösungsmittel aufgebracht und eine solche Temperatur eingestellt wird, bei der eine Tröpfchenbildung des Lösungsmittels erfolgt, danach der zu kristallisierende Stoff abgeschieden und die Temperatur größer oder gleich der Liquidustemperatur eingestellt wird, nach dem Lösen des zu kristallisierenden Stoffes in dem Lösungsmittel die Temperatur für die Kristallitbildung an der Grenzfläche Lösung/Substrat verringert wird und abschließend diese Kristallite zu einer vollständig geschlossenen kristallinen Schicht ausgewachsen werden.

2. Verfahren nach Anspruch 1,
**dadurch gekennzeichnet, daß**
die Größe der Tröpfchen und ihre Verteilungsdichte über die Menge des aufgebrachten Lösungsmittels und über die Substrattemperatur eingestellt werden.

3. Verfahren nach Anspruch 1,
**dadurch gekennzeichnet, daß**
ein Substrat mit Oberflächenrelief verwendet wird und auf dieses Oberflächenrelief ein Lösungsmittel aufgebracht wird.

4. Verfahren nach einem der Ansprüche 1 bis 3,
**dadurch gekennzeichnet, daß**
als Substrat Glas verwendet wird.

5. Verfahren nach einem der Ansprüche 1 bis 3,
**dadurch gekennzeichnet, daß**
als Substrat Keramik verwendet wird.

6. Verfahren nach Anspruch 1,
**dadurch gekennzeichnet, daß**
vor der Abscheidung des Lösungsmittels eine Haftvermittlungsschicht aufgebracht wird.

7. Verfahren nach Anspruch 1 oder 2,
**dadurch gekennzeichnet, daß**
zur Bildung von Lösungsmitteltröpfchen das Substrat während des Aufbringens des Lösungsmittels erwärmt wird.

8. Verfahren nach Anspruch 1 oder 2
**dadurch gekennzeichnet, daß**
zur Bildung von Lösungsmitteltröpfchen das Substrat nach Aufbringen des Lösungsmittels erwärmt wird.

9. Verfahren nach Anspruch 3,
**dadurch gekennzeichnet, daß**
das Oberflächenrelief im Substrat mittels eines Kurzpulslasers, insbesondere eines Femtosekundenlasers, erzeugt wird.

10. Verfahren nach Anspruch 3,
**dadurch gekennzeichnet, daß**
das Oberflächenrelief im Substrat mittels chemischen Ätzens erzeugt wird.

11. Verfahren nach Anspruch 3,
**dadurch gekennzeichnet, daß**
das Oberflächenrelief im Substrat mechanisch erzeugt wird.

12. Verfahren nach Anspruch 1 oder 3,
**dadurch gekennzeichnet, daß**
der zu kristallisierende Stoff auf das in flüssigem oder festem Zustand in Tröpfchenform auf der Substratoberfläche bzw. im Oberflächenrelief angeordnete Lösungsmittel abgeschieden wird.

13. Verfahren nach Anspruch 1,
**dadurch gekennzeichnet, daß**
das Lösungsmittel und der zu kristallisierende Stoff in einem Koprozeß gleichzeitig aus separaten Quellen auf das Substrat abgeschieden werden.

14. Verfahren nach Anspruch 1,
**dadurch gekennzeichnet, daß**
das Lösungsmittel gemeinsam mit in bereits gelöster bzw. fein disperser Form vorliegendem zu kristallisierenden Stoff abgeschieden wird.

15. Verfahren nach Anspruch 1,
**dadurch gekennzeichnet, daß**
das Lösungsmittel und der zu kristallisierende Stoff mindestens teilweise zeitlich zueinander versetzt aufgebracht werden.

16. Verfahren nach Anspruch 1 und einem der Ansprüche 13 bis 15,
**dadurch gekennzeichnet, daß**
das Lösungsmittel und der zu kristallisierende Stoff auf ein erwärmtes Substrat abgeschieden werden.

17. Verfahren nach Anspruch 1 und einem der Ansprüche 13 bis 15,
**dadurch gekennzeichnet, daß**
zur Tröpfchenbildung das Substrat nach der Abscheidung von Lösungsmittel und zu kristallisierendem Stoff erwärmt wird.

18. Verfahren nach Anspruch 1,
**dadurch gekennzeichnet, daß**
das Lösungsmittel in definiert einstellbarer geometrischer Verteilung und Tröpfchengröße auf das Substrat aufgebracht wird.

19. Verfahren nach einem der vorangehenden Ansprüche,
**dadurch gekennzeichnet, daß**
die Verfahrensschritte Aufbringen des Lösungsmittels und Aufbringen des zu kristallisierenden Stoffes mehrmals wiederholt werden.

20. Verfahren nach einem der Ansprüche 1, 12 bis 17 und 19,
**dadurch gekennzeichnet, daß**
als zu kristallisierender Stoff ein Element verwendet wird.

21. Verfahren nach einem der Ansprüche 1, 12 bis 17 und 19,
**dadurch gekennzeichnet, daß**
als zu kristallisierender Stoff Mischkristallverbindungen verwendet werden.

22. Verfahren nach einem der Ansprüche 1 bis 3, 6 und 7 und 11 bis 18,
**dadurch gekennzeichnet, daß**
einkomponentige Lösungsmittel verwendet werden.

23. Verfahren nach einem der Ansprüche 1 bis 3, 7 und 8 und 12 bis 19,
**dadurch gekennzeichnet, daß**
mehrkomponentige Lösungsmittel verwendet werden.

24. Verfahren nach Anspruch 1,
**dadurch gekennzeichnet, daß**
zur Kristallitbildung an der Grenzfläche Lösung/Substrat die Temperatur des Substrats auf eine Temperatur verringert wird, die unter der Liquidustemperatur liegt.

25. Verfahren nach Anspruch 24,
**dadurch gekennzeichnet, daß**
für die Kristallitbildung die Temperatur des Substrats durch aktive Kühlung der Substratrückseite verringert wird.

26. Verfahren nach Anspruch 1,
**dadurch gekennzeichnet, daß**
nach erfolgter Kristallitbildung der Tröpfchenrest entfernt wird.

27. Verfahren nach Anspruch 1,
**dadurch gekennzeichnet, daß**
das epitaktische Auswachsen der Kristallite in situ erfolgt.

28. Verfahren nach Anspruch 1,
**dadurch gekennzeichnet, daß**
das epitaktische Auswachsen der Kristallite ex situ erfolgt.

## Claims

1. Method for producing crystalline layers, in which nucleus centres are generated on a substrate on the surface of the substrate in a locally selective manner, characterised in that in order to generate the locally selective nucleus centres a solvent is applied to the substrate surface and such a temperature is set at which droplets of the solvent are formed, subsequently the substance that is to be crystallized is deposited thereon and the temperature is set so as to be greater than or equal to the liquidus temperature, after the substance that is to be crystallized has dissolved in the solvent the temperature for the crystallite formation is reduced at the interface solution/substrate and finally these crystallites are grown to form a completely closed crystalline layer.

2. Method according to claim 1, characterised in that the size of the droplets and their distribution density are adjusted by way of the quantity of the solvent applied and by way of the substrate temperature.

3. Method according to claim 1, characterised in that a substrate that has surface relief is used and a solvent is applied to this surface relief.

4. Method according to one of claims 1 to 3, characterised in that glass is used as the substrate.

5. Method according to one of claims 1 to 3, characterised in that ceramic material is used as the substrate.

6. Method according to claim 1, characterised in that an adhesion-promoting layer is applied before the solvent is deposited.

7. Method according to claim 1 or 2, characterised in that in order to form droplets of solvent the substrate is heated during the application of the solvent.

8. Method according to claim 1 or 2, characterised in that in order to form droplets of solvent the substrate is heated after application of the solvent.

9. Method according to claim 3, characterised in that the surface relief is produced in the substrate by means of a short-pulse laser, in particular a femtosecond laser.

10. Method according to claim 3, characterised in that the surface relief is produced in the substrate by means of chemical etching.

11. Method according to claim 3, characterised in that the surface relief is produced in the substrate mechanically.

12. Method according to claim 1 or 3, characterised in that the substance that is to be crystallized is deposited onto the solvent that is provided in a liquid or solid state in droplet form on the substrate surface or in the surface relief.

13. Method according to claim 1, characterised in that the solvent and the substance that is to be crystallized are deposited onto the substrate in a joint process simultaneously from separate sources.

14. Method according to claim 1, characterised in that the solvent is deposited together with the substance that is to be crystallized and which is present in an already dissolved or finely dispersed form.

15. Method according to claim 1, characterised in that the solvent and the substance that is to be crystallized are applied at least in a to some extent staggered manner with respect to time.

16. Method according to claim 1 and one of claims 13 to 15, characterised in that the solvent and the substance that is to be crystallized are deposited onto a heated substrate.

17. Method according to claim 1 and one of claims 13 to 15, characterised in that in order to form droplets the substrate is heated after the deposition of solvent and the substance that is to be crystallized.

18. Method according to claim 1, characterised in that the solvent is applied to the substrate with geometric distribution and droplet size that can be adjusted in a defined manner.

19. Method according to one of the preceding claims, characterised in that the method steps, application of the solvent and application of the substance that is to be crystallized, are repeated several times.

20. Method according to one of claims 1, 12 to 17 and 19, characterised in that an element is used as the substance that is to be crystallized.

21. Method according to one of claims 1, 12 to 17 and 19, characterised in that mixed crystal compounds are used as the substance that is to be crystallized.

22. Method according to one of claims 1 to 3, 6 and 7 and 11 to 18, characterised in that one-component solvents are used.

23. Method according to one of claims 1 to 3, 7 and 8 and 12 to 19, characterised in that multi-component solvents are used.

24. Method according to claim 1, characterised in that in order to form crystallites at the interface solution/substrate the temperature of the substrate is reduced to a temperature which lies below the liquidus temperature.

25. Method according to claim 24, characterised in that for the formation of crystallites the temperature of the substrate is reduced by actively cooling the rear side of the substrate.

26. Method according to claim 1, characterised in that after crystallites have been formed, the droplet residue is removed.

27. Method according to claim 1, characterised in that the epitaxial growth of the crystallites is effected in situ.

28. Method according to claim 1, characterised in that the epitaxial growth of the crystallites is effected ex situ.

## Revendications

1. Procédé pour la production de couches cristallines, dans lequel on produit sur un substrat des centres de nucléation sélectifs localement,
caractérisé en ce que
pour la production des centres de nucléation sélectifs localement, on applique un solvant sur la surface du substrat et on ajuste une température à laquelle il s'effectue une formation de gouttelettes du solvant, puis on dépose la substance à cristalliser et on règle la température à une valeur égale ou supérieure à la température de liquides, après la dissolution de la substance à cristalliser dans le solvant, on abaisse la température pour la formation de cristallites à l'interface solution/substrat et ces cristallites sont enfin totalement développés, pour donner une couche cristalline couvrant complètement.

2. Procédé selon la revendication 1,
caractérisé en ce que
la taille des gouttelettes et leur densité de répartition sont ajustées au moyen de la quantité du solvant appliqué et au moyen de la température du substrat.

3. Procédé selon la revendication 1,
caractérisé en ce qu'
on utilise un substrat à relief superficiel et on applique un solvant sur ce relief superficiel.

4. Procédé selon l'une quelconque des revendications 1 à 3,
caractérisé en ce qu'
en tant que substrat, on utilise du verre.

5. Procédé selon l'une quelconque des revendications 1 à 3,
caractérisé en ce qu'
en tant que substrat, on utilise de la céramique.

6. Procédé selon la revendication 1,
caractérisé en ce qu'
avant le dépôt du solvant on applique une couche favorisant l'adhérence.

7. Procédé selon la revendication 1 ou 2,
caractérisé en ce que
pour la formation de gouttelettes de solvant, on chauffe le substrat pendant l'application du solvant.

8. Procédé selon la revendication 1 ou 2,
caractérisé en ce que
pour la formation de gouttelettes de solvant, on chauffe le substrat après l'application du solvant.

9. Procédé selon la revendication 3,
caractérisé en ce que
le relief superficiel dans le substrat est produit au moyen d'un laser à courtes impulsions, en particulier un laser à impulsions de l'ordre de femtosecondes.

10. Procédé selon la revendication 3,
caractérisé en ce que
le relief superficiel dans le substrat est engendré par attaque chimique.

11. Procédé selon la revendication 3,
caractérisé en ce que
le relief superficiel dans le substrat est engendré mécaniquement.

12. Procédé selon la revendication 1 ou 3,
caractérisé en ce que
la substance à cristalliser est déposée sur le solvant disposé à l'état liquide ou solide, sous forme de gouttelettes sur la surface du substrat ou dans le relief superficiel.

13. Procédé selon la revendication 1,
caractérisé en ce que
le solvant et la substance à cristalliser sont déposés simultanément sur le substrat, dans un co-processus, à partir de sources distinctes.

14. Procédé selon la revendication 1,
caractérisé en ce que
le solvant est déposé conjointement avec la substance à cristalliser, se trouvant déjà sous forme dissoute ou finement dispersée.

15. Procédé selon la revendication 1,
caractérisé en ce que
le solvant et la substance à cristalliser sont appliqués au moins en partie séparément l'un de l'autre dans le temps.

16. Procédé selon la revendication 1 et l'une quelconque des revendications 13 à 15,
caractérisé en ce que
le solvant et la substance à cristalliser sont déposés sur un substrat chauffé.

17. Procédé selon la revendication 1 et l'une quelconque des revendications 13 à 15,
caractérisé en ce que
pour la formation de gouttelettes, le substrat est chauffé après le dépôt du solvant et de la substance à cristalliser.

18. Procédé selon la revendication 1,
caractérisé en ce que
le solvant est appliqué sur le substrat en une répartition géométrique et à une taille de particules pouvant être ajustées de façon définie.

19. Procédé selon l'une quelconque des revendications précédentes,
caractérisé en ce qu'
on répète plusieurs fois les étapes de processus application du solvant et application de la substance à cristalliser.

20. Procédé selon l'une quelconque des revendications 1, 12 à 17 et 19,
caractérisé en ce que
comme substance à cristalliser, on utilise un élément.

21. Procédé selon l'une quelconque des revendications 1, 12 à 17 et 19,
caractérisé en ce que
comme substance à cristalliser, on utilise des composés de type solution solide.

22. Procédé selon l'une quelconque des revendications 1 à 3, 6 et 7 et 11 à 18,
caractérisé en ce qu'
on utilise des solvants à un seul composant.

23. Procédé selon l'une quelconque des revendications 1 à 3, 7 et 8, et 12 à 19,
caractérisé en ce qu'
on utilise des solvants à plusieurs composants.

24. Procédé selon la revendication 1,
caractérisé en ce que
pour la formation de cristallites à l'interface solution/substrat, on abaisse la température du substrat jusqu'à une température qui est inférieure à la température de liquidus.

25. Procédé selon la revendication 24,
caractérisé en ce que
pour la formation de cristallites, on abaisse la température du substrat par refroidissement actif de la face arrière du substrat.

26. Procédé selon la revendication 1,
caractérisé en ce qu'
une fois effectuée la formation des cristallites, le reste des gouttelettes est éliminé.

27. Procédé selon la revendication 1,
caractérisé en ce que
la croissance épitactique des cristallites s'effectue in situ.

28. Procédé selon la revendication 1,
caractérisé en ce que
la croissance épitactique des cristallites s'effectue ex situ.
